# EUROPEAN PATENT APPLICATION

(11) **EP 4 815 676 A1**
(43) Date of publication of application: **30.09.2026**
(21) Application number: 25185938.5
(22) Date of filing: 27.06.2025
(51) Int. Cl.: H10F 10/165, H10F 77/20

(54) **SOLAR CELL, METHOD FOR PREPARING THE SAME AND PHOTOVOLTAIC MODULE**

(30) Priority: 28.03.2025 CN 202510391736
(71) Applicant: Zhejiang Jinko Solar Co., Ltd., Haining, Zhejiang 314416 (CN)
(72) Inventor: LI, Huimin, Haining, Zhejiang (CN); XU, Menglei, Haining, Zhejiang (CN); YANG, Jie, Haining, Zhejiang (CN); ZHANG, Xinyu, Haining, Zhejiang (CN)
(74) Representative: Balder IP Law, S.L.

(57) **Abstract**

Provided are a back contact solar cell, a method for preparing the same, and a photovoltaic module. The back contact solar cell includes a substrate, a first passivation contact layer, a doped oxide layer, a second passivation contact layer and a connecting layer. The substrate has a first surface and a second surface opposite to the first surface. The first surface includes alternating first doped regions and second doped regions. The first passivation contact layer is over the first doped regions. The doped oxide layer includes a first portion and a second portion. The first portion is located on a surface of the first passivation contact layer facing away from a first doped region, and the second portion extends from an end of the first portion towards a second doped region to be over the second doped region. The second passivation contact layer is over the second doped regions.

## Description

### TECHNICAL FIELD

The various embodiments described in this document relate to the photovoltaic field, and in particular, to a back contact solar cell, a method for preparing the same, and a photovoltaic module.

### BACKGROUND

An interdigitated back contact (IBC) cell refers to a back-junction and back-contact solar cell structure in which positive and negative metal electrodes are arranged in an interdigitated manner on a backlight side of the solar cell with its PN junction is located on a rear surface of the solar cell. The term "back-junction" refers to that the PN junction is located on the rear surface of the solar cell. The IBC cell is currently one of the photovoltaic cells with high conversion efficiency. The IBC cell uses monocrystalline silicon as the substrate in which both the PN junction and the metal electrodes are located its rear surface, with its front surface not shaded by any metal electrode, thereby enabling a very high short-circuit current and good conversion efficiency.

A photovoltaic module composed of multiple solar cells is usually installed in an area with wide-open space and abundant sunlight. During long-term use, it's hard to avoid obstructions such as birds, dust and fallen leaves, and these obstructions will result in shadows on the photovoltaic module. In addition, in a large array of photovoltaic modules, shadows may be formed when the interval between the photovoltaic modules is not appropriately set. Due to the local shadows, the current and voltage of some solar cells in the photovoltaic module may change. As a result, a product of the local current and voltage of the photovoltaic module may increase, thereby causing a local temperature rise in the photovoltaic module. Moreover, inherent defects of some solar cells within the photovoltaic module may also cause local temperature rise during operation, and this phenomenon is called as "hot spot effect."

In the IBC cell, since both the P-type doped regions and the N-type doped regions are located on the rear surface of the substrate and are separated from each other, during the process of forming solar cell strings by multiple IBC cells and then encapsulating them into the photovoltaic module, the hot spot effect may adversely affect the power of the photovoltaic module and may lead to safety issues caused by the local temperature rise. Therefore, how to solve the problem of the "hot spot effect" is desired.

### SUMMARY

Embodiments of the present disclosure provide a back contact solar cell, a method for preparing the same, and a photovoltaic module, which at least facilitates solving the problem of the hot spot effect and improving the photoelectric conversion efficiency.

According to some embodiments, an aspect of the embodiments of the present disclosure provides a back contact solar cell. The back contact solar cell includes a substrate, a first passivation contact layer, a doped oxide layer, a second passivation contact layer and a connecting layer. The substrate includes a first surface and a second surface opposite to the first surface, where the first surface includes first doped regions and second doped regions that are alternatingly arranged in a first direction. The first passivation contact layer is formed over the first doped regions. The doped oxide layer includes a first portion and a second portion, where the first portion is on a surface of the first passivation contact layer facing away from a respective first doped region, and the second portion extends from the first portion in the first direction and protrudes beyond the surface of the first passivation contact layer to be above a second doped region adjacent to the respective first doped region. The second passivation contact layer is formed over the second doped regions, where the second passivation contact layer has a doping type different from a doping type of the first passivation contact layer. The connecting layer is over a part of the first portion of the doped oxide layer, wraps around a part of the second portion, and is electrically connected to the second passivation contact layer, and the connecting layer extends along a side surface of the first passivation contact layer and is electrically connected to the first passivation contact layer.

In some embodiments, the second portion has a length of 0 µm to 3 µm in the first direction.

In some embodiments, a first distance between the second surface and the respective first doped region is greater than a second distance between the second surface and the second doped region, the respective first doped regions defines a groove together with the second doped region, the second portion is over the groove, the connecting layer is over an inner side surface of the groove, and the second passivation contact layer is over a bottom surface of the groove.

In some embodiments, a difference between the first distance and the second distance is less than or equal to 5 µm.

In some embodiments, the first passivation contact layer is doped with a P-type doping element, and includes a third portion and a fourth portion that form a continuous layer, the third portion is opposite to the first portion, the fourth portion is opposite to the second portion, the fourth portion is over the groove, the second portion is over the fourth portion, and the connecting layer is over a side surface of the fourth portion, and a bottom surface of the fourth portion facing away from the second portion.

In some embodiments, the side surface of the fourth portion is provided with an inwardly concave recess, and the connecting layer is at least partially in the recess.

In some embodiments, an included angle between the bottom surface of the groove and the side surface of the groove is in a range of 110° to 150°.

In some embodiments, a material of the doped oxide layer includes borosilicate glass, phosphosilicate glass, borophosphosilicate glass, or fluorophosphosilicate glass.

In some embodiments, a thickness of the connecting layer is less than or equal to a thickness of the second passivation contact layer.

In some embodiments, the connecting layer includes a first connecting layer and a second connecting layer, the first connecting layer is over the part of the first portion, the second connecting layer wraps around the part of the second portion and is electrically connected to the second passivation contact layer, and a thickness of the second connecting layer is less than or equal to a thickness of the first connecting layer.

In some embodiments, a first part of the second connecting layer connected to the second passivation contact layer has a thickness less than a thickness of a part of the second connecting layer other than the first part.

According to some embodiments, an aspect of the embodiments of the present disclosure provides, the photovoltaic module includes at least one cell string, an encapsulation film, and at least one cover plate. Each of the at least one cell string is formed by connecting a plurality of back contact solar cells. The encapsulation film is configured to cover a surface of the at least one cell string. The at least one cover plate is configured to cover a surface of the encapsulation film away from the at least one cell string.

### BRIEF DESCRIPTION OF THE DRAWINGS

One or more embodiments are described by way of example with reference to the corresponding figures in the accompanying drawings, and the exemplary description is not to be construed as limiting the embodiments. Elements in the accompanying drawings that have same reference signs are represented as similar elements, and unless otherwise particularly stated, the figures in the accompanying drawings are not drawn to scale. To describe the technical solutions of the embodiments of the present disclosure or the related art more clearly, the accompanying drawings that need to be used in the embodiments are briefly described below. Apparently, the accompanying drawings in the following description show only some embodiments of the present disclosure, and a person of ordinary skill in the art may still derive other drawings from these accompanying drawings without creative efforts.
FIG. 1 is a top view of a back contact solar cell according to an embodiment of the present disclosure.
FIG. 2 is a sectional view taken along line A1-A2 in FIG. 1.
FIG. 3 is an enlarged view at B in FIG. 2.
FIG. 4 is an enlarged view of a back contact solar cell according to an embodiment of the present disclosure.
FIG. 5 is another sectional view taken along line A1-A2 in FIG. 1.
FIG. 6 is a scanning electron microscope (SEM) image of a back contact solar cell according to an embodiment of the present disclosure.
FIG. 7 is an enlarged view of a first passivation contact structure and a substrate in a back contact solar cell according to an embodiment of the present disclosure.
FIG. 8 is an enlarged view of a first doped semiconductor layer in the first passivation contact structure in FIG. 7.
FIGS. 9 to 14 are sectional views of a back contact solar cell at respective operations in a method of manufacturing the back contact solar cell according to another embodiment of the present disclosure.
FIG. 15 is a sectional view of a photovoltaic module according to yet another embodiment of the present disclosure.

### DETAILED DESCRIPTION OF THE EMBODIMENTS

As is known from the background technology, current back-contact solar cells suffer from hot spot effect and does not exhibit relatively high photoelectric conversion efficiency.

Embodiments of the present disclosure provide a back contact solar cell, a preparation method thereof, and a photovoltaic module. In the back contact solar cell, a doped oxide layer is provided to improve the interfacial state charge between a first passivation contact layer and a connecting layer to reduce leakage current; the doped oxide layer is provided over a second doped region to reduce the thickness of the connecting layer; the connecting layer is provided to be indirectly and directly contact the first passivation contact layer and another end of the connecting layer is in contact with the second passivation contact layer, so as to form a leakage channel and improve the hot spot effect, thereby ensuring the yield of the ultimately formed photovoltaic module as well as the photovoltaic conversion efficiency of the back-contact solar cell itself.

In the description of the embodiments of the present disclosure, the technical terms "first" "second" and the like are only used to distinguish different objects and cannot be understood as indicating or implying relative importance or implicitly indicating the number, specific order, or primary and secondary relationship of the indicated technical features. In the description of the embodiments of the present disclosure, "a plurality of" means at least two, unless otherwise specified.

In the description of the embodiments of the present disclosure, the term "and/or" is merely an association relationship describing associated objects, indicating that there may be three relationships, for example, A and/or B (or at least one of A and B), which may indicate that A exists, A and B exist at the same time, and B exists. In addition, the character "/" in this specification generally indicates an "or" relationship between the associated objects.

In the description of the embodiments of the present disclosure, the term "a plurality of" means at least two, similarly, "a plurality of groups" means at least two groups, and "a plurality of pieces" means at least two pieces.

In the description of the embodiments of the present disclosure, orientation or positional relationship indicated by technical terms "center", "transverse", "longitudinal", "length", "width", "thickness", "up", "down", "front", "rear", "left", "right", "vertical", "horizontal", "top", "bottom", "inside" "outside", "clockwise", "counterclockwise", "axial", "radial", "circumferential" and the like are orientations or positional relationships based on those shown in the accompanying drawings, which are intended only to facilitate the description of embodiments of the present disclosure and to simplify the description, and are not intended to indicate or imply that the device or element referred to must have a particular orientation, be constructed and operated with a particular orientation, and therefore are not to be construed as a limitation of the embodiments of the present disclosure.

In the description of the embodiments of the present disclosure, unless otherwise specified and limited, technical terms "mounted", "connected", "connecting", "fixed", etc. are to be understood in a broad sense. For example, it may be a fixed connection, a removable connection, or a one-piece connection, it may be a mechanical connection, or an electrical connection, it may be a direct connection, or an indirect connection through an intermediate medium, and it may be a connection between two elements or an interaction between the two elements. For those of ordinary skill in the art, specific meanings of the above terms in the embodiments of the present disclosure may be understood according to specific situations.

In the accompanying drawings corresponding to the embodiments of the present disclosure, for better understanding and ease of description, the thickness and area of a layer are enlarged. When a component (e.g., a layer, a film, a region, or a substrate) is described as being formed over another component or over a surface of another component, the component may be "directly" on the surface of another component, or a third component may exist between the two components. In contrast, when a component is described as being formed on a surface of another component or a surface of a component is formed or provided with another component, there is no third component between the two components. In addition, when a component is described as being "substantially" formed on/over another component, it means that the component is not formed on/over the entire surface (or front surface) of another component, nor on/over a portion of the edge of the entire surface.

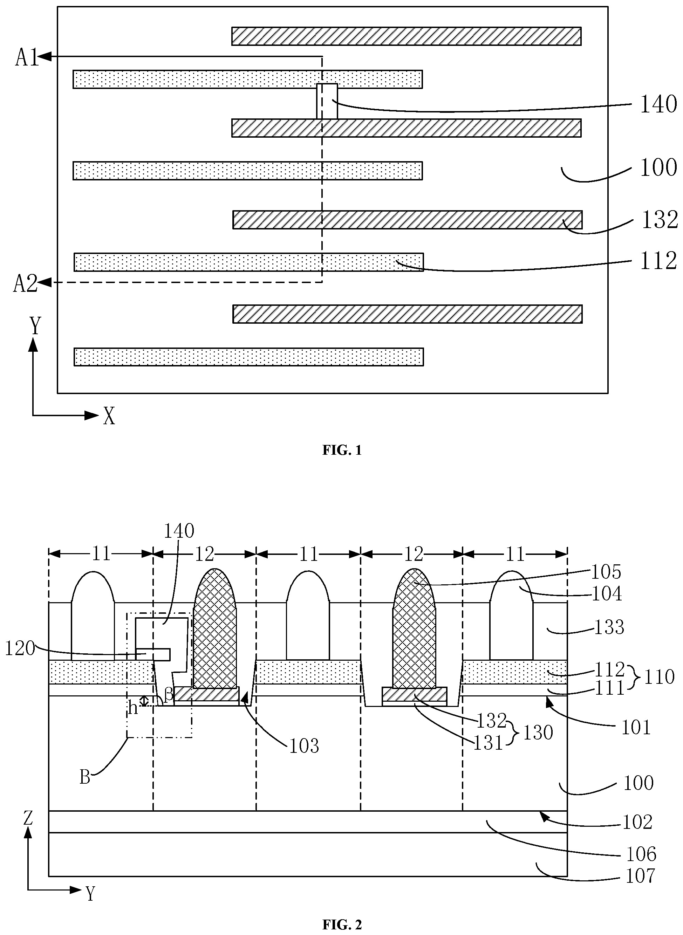

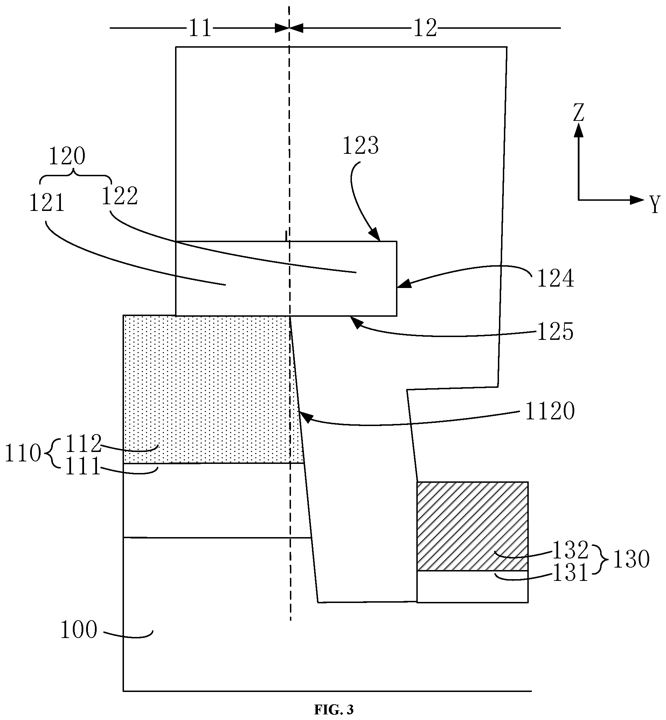

FIG. 1 is a top view of a back contact solar cell according to an embodiment of the present disclosure. FIG. 2 is a sectional view taken along line A1-A2 in FIG. 1. FIG. 3 is an enlarged view at B in FIG. 2.

Referring to FIGS. 1 to 3, according to some embodiments of the present disclosure, an aspect of the embodiments of the present disclosure provide a back contact solar cell. The back contact solar cell includes a substrate 100, a first passivation contact layer 110, a doped oxide layer 120, a second passivation contact layer 130 and a connecting layer 140. The substrate 100 includes a first surface 101 and a second surface 102 opposite to the first surface 101, where the first surface 101 includes first doped regions 11 and second doped regions 12 that are alternatingly arranged in a first direction Y. The first passivation contact layer 110 is formed over the first doped regions 11. The doped oxide layer 120 includes a first portion 121 and a second portion 122, where the first portion 121 is on a surface of the first passivation contact layer 110 facing away from a respective first doped region 11, and the second portion 122 extends from the first portion 121 in the first direction and protrudes beyond the surface of the first passivation contact layer to be above a second doped region 12 adjacent to the respective first doped region 11. The second passivation contact layer 130 is formed over the second doped regions 12, where the second passivation contact layer 130 has a doping type different from a doping type of the first passivation contact layer 110. The connecting layer 140 is over a part of the first portion 121, wraps around a part of the second portion 122, and is electrically connected to the second passivation contact layer 130, and the connecting layer 140 extends along a side surface of the first passivation contact layer 110 and is electrically connected to the first passivation contact layer 110.

In the back contact solar cell according to the embodiments of the present disclosure, the first doping regions 11 and the second doping regions 12 are provided on the substrate 100, and the first passivation contact layer 110 and the second passivation contact layer 130 are respectively formed on the first doping regions 11 and the second doping regions 12. The carrier recombination rate of the substrate surface can be reduced based on the chemical passivation and field passivation of the first passivation contact layer 110 and the second passivation contact layer 130, so that the photoelectric conversion efficiency of the back contact solar cell is improved. In addition, the connecting layer 140 is provided to be on the doping oxide layer 120 and electrically connected to the second passivation contact layer 130. A part of the connecting layer 140 located on the doping oxide layer 120 indirectly contacts the first passivation contact layer 110 through the doping oxide layer 120, and due to the dielectric film characteristics of the doping oxide layer 120 itself and small carrier mobility, the leakage channel formed by the connecting layer 140 through the doping oxide layer 120 is limited, thereby moderately mitigating the hot spot effect while avoiding significant degradation of photoelectric conversion efficiency. The connecting layer 140 also contacts the side surface of the first passivation contact layer 110, so that the connecting layer 140 directly contacts the first passivation contact layer 110, and one end of the connecting layer 140 also directly contacts the second passivation contact layer 130, so that a direct leakage channel can be formed, thereby significantly mitigating the hot spot effect. Due to the limited contact area of the side surface and the constraints imposed by the deposition process, the thickness of the connecting layer 140 located on the side surface is not excessively large, and restricts the dimension of the leakage current path in this region, thereby avoiding significant degradation of photoelectric conversion efficiency. Through the two connection modes, the indirect contact of the connecting layer 140 with the first passivation contact layer 110 and the direct contact of the connecting layer 140 with the side surface of the first passivation contact layer 110, the hot spot effect is mitigated, so that the yield of the finally formed photovoltaic module and the photoelectric conversion efficiency of the back contact solar cell itself can be ensured.

In addition, the doped oxide layer 120 is disposed on part of the first passivation contact layer 110, and can reduce the interface state charge on the surface of the first passivation contact layer 110, thereby improving the electric field distribution between the first passivation contact layer 110 and the connecting layer 140 and between the first passivation contact layer 110 and the substrate, and avoiding the generation of large leakage current and other adverse effects caused by the interface state charge. Further, the doped oxide layer 120 is located on the surface of part of the first passivation contact layer 110 and extends to the second doped region 12. In this way, the doped oxide layer 120, the first passivation contact layer 110 and the substrate 100 form a concave structure. The connecting layer 140 deposited on the film layer subsequently is formed to have a thickness not greater than a thickness of the second passivation contact layer 130 due to the shielding of the doped oxide layer 120, thereby reducing the size of the leakage channel to ensure the balance of the leakage current and the battery efficiency.

In some embodiments, the material of the substrate 100 may be an elemental semiconductor material. Specifically, the elemental semiconductor material is composed of a single element, for example, may be silicon or germanium. The elemental semiconductor material may be in a single crystal state, a polycrystalline state, an amorphous state or a microcrystalline state (a state having both the single crystal state and the amorphous state, referred to as a microcrystalline state). For example, the silicon may be at least one of single crystal silicon, polycrystalline silicon, amorphous silicon or microcrystalline silicon.

In some embodiments, the material of the substrate 100 may be a compound semiconductor material. Common compound semiconductor materials include, but are not limited to, silicon germanium, silicon carbide, gallium arsenide, indium gallium, perovskite, cadmium telluride, copper indium selenium and the like. The substrate 100 may also be a sapphire substrate, a silicon-on-insulator substrate or a germanium-on-insulator substrate.

In some embodiments, the substrate 100 may be an N-type semiconductor substrate or a P-type semiconductor substrate. The N-type semiconductor substrate is doped with an N-type doping element, which may be any one of a group V element such as a phosphorus (P) element, a bismuth (Bi) element, an antimony (Sb) element or an arsenic (As) element. The P-type semiconductor substrate is doped with a P-type doping element, which may be any one of a group III element such as a boron (B) element, an aluminum (Al) element, a gallium (Ga) element or an indium (In) element.

In some embodiments, the first surface 101 is a rear surface, and the second surface 102 is a front surface. Here, "front" and "rear" in the front surface and the rear surface are relative, that is, "front" refers to a surface facing the sunlight in the vertical direction, and "rear" refers to a surface facing away from the sunlight in the vertical direction.

In some embodiments, the back contact solar cell is a single-sided cell, the front surface may be used as a light receiving surface for receiving incident light, and the rear surface is a backlight surface. Here, the back light surface can also receive incident light, but the efficiency of receiving incident light is lower than that of the light receiving surface.

In some embodiments, the back contact solar cell is a double-sided cell, that is, both the front surface and the rear surface of the substrate may be used as light receiving surfaces for receiving incident light.

In some embodiments, the first doped region 11 refers to a region where the first electrode 104 is orthogonally projected on the reference surface, and the first doped region 11 is a functional region for forming a first type metal electrode. Similarly, the second doped region 12 refers to a region where the second electrode 105 is orthogonally projected on the reference surface, and the second doped region 12 is a functional region for forming a second type metal electrode.

In some embodiments, the first doped region 11 and the second doped region 12 have a spacing region (also referred to as a non-metal electrode region), and the spacing region refers to a region that does not overlap with orthogonal projections of the first electrode 104 and the second electrode 105 on the reference surface, that is, the spacing region is a functional region for not forming a metal electrode. In other embodiments, the first doped region 11 and the second doped region 12 do not have a spacing region, but have a height difference, and a film layer on the first doped region 11 and a film layer on the second doped region 12 do not contact each other.

It should be noted that, in order to ensure that the film layers contacted by the first electrode 104 and the second electrode 105 are corresponding functional film layers, the first doped region 11 is arranged to have a range greater than or equal to a range of the orthographic projection of the first electrode 104 on the reference surface, that is, any orthographic projection of the first electrode 104 on the reference surface is located in the first doped region 11, and a distance between an edge of the first doped region 11 and an edge of the orthographic projection is greater than or equal to 0. Similarly, the second doped region 12 has a range greater than or equal to a range of the orthographic projection of the second electrode 105 on the reference surface. The reference surface is a flat surface perpendicular to a thickness direction Z of the substrate 100. The reference surface is parallel to a surface formed by the second direction X and the first direction Y.

In addition, the first doped region 11, the second doped region 12, and the interval region are regions set by functional partitioning of the substrate 100 (or the first surface 101) to illustrate the distribution of the film layer structures of the back contact solar cell. In actually, the three regions all belong to the substrate 100 (or the first surface 101), and there is no boundary between the different regions. The film layers on the regions may be different, for example, the first passivation contact layer 110 is formed over the first doped region 11, the second passivation contact layer 130 is formed over the second doped region 12, the passivation layer is formed over most of the interval region, and the connecting layer 140 is formed over part of the interval region.

In some embodiments, the first doped region 11 is one of an N region or a P region, and the second doped region 12 is the other of the N region or the P region.

In some embodiments, a first distance between the first doped region 11 and the second surface 102 is greater than a second distance between the second doped region 12 and the second surface 102. The first doped region 11 has a groove 103 relative to the second doped region 12, the second portion 122 is located over the groove 103, the connecting layer 140 extends along an inner side surface of the groove 103, and the second passivation contact layer 130 is located on a bottom surface of the groove 103.

In some embodiments, referring to FIG. 2, a difference between the first distance and the second distance is less than or equal to 5 µm, that is, a depth h of the groove 103 is less than or equal to 5 µm. In this way, the first surface 101 of the substrate 100 is a rough surface with a concave-convex structure, and the refractive index for the incident light can be increased based on the limitation of the groove 103, thereby improving the photoelectric conversion efficiency of the back contact solar cell. In addition, since the height difference between the first doped region 11 and the second doped region 12 is less than or equal to 5 µm, and the thickness of the second passivation contact layer 130 formed over the second doped region 12 is usually less than 2 µm, the function of the spacing region can be realized based on the height difference between the first doped region 11 and the second doped region 12, so that the spacing region does not need to be additionally set, thereby increasing the area of carrier collection, and thereby improving the photoelectric conversion efficiency of the carriers.

Further, the depth h of the groove 103 is in a range of 0.5 µm to 1.5 µm. When the depth h of the groove 103 is in this range, an etched depth of the substrate 100 can be controlled, so that the substrate 100 can be etched less while ensuring that the first passivation contact layer 110 on the second doped region 12 is completely etched, thereby avoiding the adverse effects caused by excessive etching of the substrate. In addition, the time for etching the substrate 100 and the amount of etching liquid can be reduced, and the preparation cost can be reduced.

In some embodiments, the depth h of the groove 103 may be 0.5 µm, 0.8 µm, 1.2 µm, 1.5 µm, 2.3 µm, 2.6 µm, 3.1 µm, 3.8 µm, 4.2 µm, 4.5 µm, or 4.9 µm.

In some embodiments, an included angle β between the bottom surface of the groove 103 and the side surface of the groove 103 is in a range of 110° to 150°. In this way, an obtuse angle is formed between the bottom surface of the groove 103 and the side surface of the groove 103, and the side surface of the groove 103 is inclined relative to the bottom surface, thereby increasing the internal reflectivity of the incident light. The inclined surface at least causes the thickness of the connecting layer 140 located thereon to be less than or equal to the thickness of the connecting layer 140 in other regions, thereby reducing the size of the leakage channel.

The included angle β between the bottom surface of the groove 103 and the side surface of the groove 103 may be 110°, 115°, 120°, 125°, 130°, 135°, 140°, 145°, or 150°.

In some embodiments, the first passivation contact layer 110 includes a first tunneling dielectric layer 111 and a first doped semiconductor layer 112. The first tunneling dielectric layer 111 is located on the first doped region 11. The first doped semiconductor layer 112 is located on a surface of the first tunneling dielectric layer 111. A passivation layer 133 is formed on a surface of the first doped semiconductor layer 112. The first electrode 104 is electrically connected to the first doped semiconductor layer 112.

The first doped semiconductor layer 112 can form a band bending on the surface of the substrate 100. The first tunneling dielectric layer 111 causes the band on the surface of the substrate 100 to asymmetrically shift, so that a barrier to majority carriers in the carriers is lower than a barrier to minority carriers in the carriers. Therefore, the majority carriers can easily tunnel through the first tunneling dielectric layer 111 via quantum tunneling, while the minority carriers are difficult to pass through the first tunneling dielectric layer 111, so as to achieve selective transmission of the carriers.

In addition, the first tunneling dielectric layer 111 has a chemical passivation effect. Specifically, since there are interface state defects at the interface between the substrate 100 and the first tunneling dielectric layer 111, the interface state density of the first surface 101 is relatively large, and the increase of the interface state density promotes the recombination of photo-generated carriers, which reduces the fill factor, the short-circuit current and the open-circuit voltage of the back contact solar cell, and thus reduces the photoelectric conversion efficiency of the back contact solar cell. The first tunneling dielectric layer 111 is disposed on the first surface 101, so that the first tunneling dielectric layer 111 has a chemical passivation effect on the surface of the substrate 100. Specifically, by saturating dangling bonds of the substrate 100, the defect state density of the substrate 100 is reduced, and the recombination centers of the substrate 100 are reduced to reduce the carrier recombination rate.

The first doped semiconductor layer 112 has a field passivation effect. Specifically, an electrostatic field is formed on the surface of the substrate 100 and points to the inside of the substrate 100, so that the minority carriers escape from the interface, thereby reducing the minority carrier concentration, reducing the carrier recombination rate at the interface of the substrate 100, increasing the open-circuit voltage, the short-circuit current and the fill factor of the back contact solar cell, and thus improving the photoelectric conversion efficiency of the back contact solar cell.

In some embodiments, a thickness of the first tunneling dielectric layer 111 is 0.5 nm to 10 nm. For example, the thickness of the first tunneling dielectric layer 111 is in a range of 0.5 nm to 1.3 nm, 1.3 nm to 4.6 nm, 4.6 nm to 6.1 nm, or 6.1 nm to 10 nm. When the thickness of the first tunneling dielectric layer 111 is in any of the above ranges, the thickness of the first tunneling dielectric layer 111 is relatively thin, and the majority carriers can easily tunnel through the first tunneling dielectric layer 111 via quantum tunneling, while the minority carriers are difficult to pass through the first tunneling dielectric layer 111, so as to achieve selective transmission of the carriers.

In some embodiments, the material of the first tunneling dielectric layer 111 includes at least one of silicon oxide, amorphous silicon, microcrystalline silicon, nanocrystalline silicon, or silicon carbide.

In some embodiments, the first doped semiconductor layer 112 includes at least one of a doped amorphous silicon layer, a doped polysilicon layer, a doped microcrystalline silicon layer, a doped silicon carbide layer, or a doped crystalline silicon layer.

In some embodiments, the second passivation contact layer 130 includes a second tunneling dielectric layer 131 over the second doped regions 12, and a second doped semiconductor layer 132 on a surface of the second tunneling dielectric layer 131. A passivation layer 133 is on a surface of the second doped semiconductor layer 132, and a second electrode 105 is electrically connected to the second doped semiconductor layer 132. One end of the connecting layer 140 is electrically connected to the second doped semiconductor layer 132.

The function, material, and thickness of the second tunneling dielectric layer 131 may be set with reference to the above-described first tunneling dielectric layer 111. The function and material of the second doped semiconductor layer 132 may be set with reference to the above-described first doped semiconductor layer 112.

The first doped semiconductor layer 112 and the second doped semiconductor layer 132 differ in that the first doped semiconductor layer 112 is one of an N-type doped layer and a P-type doped layer, and the second doped semiconductor layer 132 is the other of the N-type doped layer and the P-type doped layer.

In some embodiments, the doping element in the first doped semiconductor layer 112 and the doping element in the substrate 100 are of the same conductivity type. For example, the substrate 100 has an N-type doping element, and the first doped semiconductor layer 112 has an N-type doping element. Alternatively, the substrate 100 has a P-type doping element, and the first doped semiconductor layer 112 has a P-type doping element. In this way, the doping elements of the first doped semiconductor layer 112 and the substrate 100 are of the same conductivity type, so that by setting the concentration of the doping element in the first doped semiconductor layer 112 to be greater than the concentration of the doping element in the substrate 100, a high-low junction is formed between the substrate 100 and the first doped semiconductor layer 112. Under the action of a built-in electric field formed by the high-low junction, carriers can quickly migrate from the substrate 100 to the first doped semiconductor layer 112, and then be collected by the first electrode 104.

Correspondingly, the doping element in the second doped semiconductor layer 132 and the doping element in the substrate 100 are of different conductivity types. For example, the substrate 100 has an N-type doping element, and the second doped semiconductor layer 132 has a P-type doping element. Alternatively, the substrate 100 has a P-type doping element, and the second doped semiconductor layer 132 has an N-type doping element. In this way, a PN junction is formed between the substrate 100 and the second doped semiconductor layer 132. Minority carriers and majority carriers flow to corresponding P regions and N regions under the action of respective forces, which is conducive to accelerating the mobility of carriers.

In other embodiments, the above situation presents an opposite state, for example, the doping element in the first doped semiconductor layer 112 and the doping element in the substrate 100 are of different conductivity types, and the doping element in the second doped semiconductor layer 132 and the doping element in the substrate 100 are of the same conductivity type, which are not repeated herein.

The doping oxide layer 120 can reduce the interface state charge on the surface of the first passivation contact layer 110, thereby improving the electric field distribution between the first passivation contact layer 110 and the connecting layer 140 and between the first passivation contact layer 110 and the substrate 100, and avoiding generation of a large leakage current and other adverse effects caused by the interface state charge. In addition, the doping oxide layer 120 is located on the surface of part of the first passivation contact layer 110 and extends to the second doping region 12. In this way, a concave structure is formed by the doping oxide layer 120, the first passivation contact layer 110 and the substrate 100. The connecting layer 140 deposited on the film layer subsequently is formed to have a thickness not greater than a thickness of the second passivation contact layer 130 due to the shielding of the doped oxide layer 120, thereby reducing the size of the leakage channel to ensure the balance of the leakage current and the battery efficiency.

In some embodiments, the material of the doping oxide layer 120 includes boron silicate glass, phosphorus silicate glass, boron phosphorus glass or fluorine phosphorus glass.

In some embodiments, the thickness of the doping oxide layer 120 is 0 nm to 120 nm, and further, the thickness of the doping oxide layer 120 is 10 nm to 50 nm. The thickness of the doping oxide layer is 10 nm, 20 nm, 30 nm, 40 nm, 50 nm, 60 nm, 70 nm, 80 nm, 90 nm, 100 nm, 110 nm or 120 nm.

In some embodiments, the doping oxide layer 120 has a doping element, which may be the first doping element of the first doping semiconductor layer 112. The doping element can act as a carrier, so that the connecting layer 140 and the first doping semiconductor layer 112 may be electrically connected to each other through the doping element to improve the effect of the leakage current.

In some embodiments, the doping oxide layer 120 has doping elements, which may be the first doping element of the first doped semiconductor layer 112 and the second doping element of the second doped semiconductor layer 132, and a doping concentration of the first doping element is greater than a doping concentration of the second doping element. In this way, the ratio of the doping concentration of the first doping element to the doping concentration of the second doping element can be adjusted to improve the ability of the doping oxide layer 120 to recombine interface state charges, thereby controlling the leakage current. In addition, controlling the concentration ratio of the first doping element to the second doping element can change the performance of the doping oxide layer 120 itself, and at least enable the mobility of the doping oxide layer 120 to be strong, thereby reducing defects of the first doped semiconductor layer 112 and improving the flatness of the first doped semiconductor layer 112. This also at least enables the decomposition ability of the doping oxide layer 120 to be weak, so that the doping oxide layer 120 will not decompose into acid when absorbing sodium ions in the subsequent process, thereby affecting the photoelectric conversion efficiency of the back contact solar cell.

In some embodiments, a length of the second portion 122 along the first direction Y is in a range of 0 µm to 3 µm, where the first direction Y refers to a direction in which the second doped region 12 points to the first doped region 11. The length of the second portion 122 may be such that the thickness of the connecting layer 140 located on the side surface 1120 is not too thin, thereby forming a leakage channel to reduce the hot spot effect, and at the same time, due to the shielding of the second portion 122, the thickness of the connecting layer 140 is not excessively large so that the size of the leakage channel is limited, which prevents a significant amount of electron-hole recombination, thereby avoiding a substantial reduction in photoelectric conversion efficiency. The length of the second portion 122 along the first direction Y may be 0.5 µm, 1 µm, 1.5 µm, 2 µm, 2.5 µm, or 3 µm.

In some embodiments, the doping oxide layer 120 is only located on part of the first doped regions 11, and the doping oxide layer 120 is not located between the first electrode 104 and the first doped semiconductor layer 112, thereby avoiding the increase of the contact resistance between the first electrode 104 and the first doped semiconductor layer 112 due to the dielectric film characteristics of the doping oxide layer 120. The part of the first doped regions 11 described above refers to a part of the number of the first doped regions 11 and a partial region of a first doped region 11.

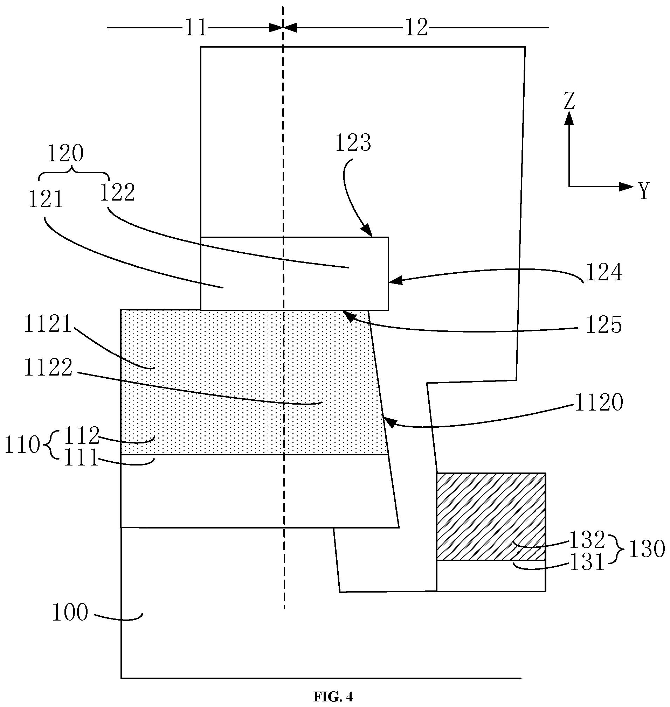

FIG. 4 is a local enlarged view of a back contact solar cell according to embodiments of the present disclosure.

Referring to FIG. 4, in some embodiments, the first passivation contact layer 110 is doped with a P-type doping element, and includes a third portion 1121 and a fourth portion 1122 that are continuous. The third portion 1121 is opposite to the first portion 121, the fourth portion 1122 is opposite to the second portion 122, the fourth portion 1122 is located over the groove 103, and the second portion 122 is located on a surface of the fourth portion 1122. The connecting layer 140 is on a side surface of the fourth portion 1122, and a bottom surface of the fourth portion 1122 away from the second portion 122. In this way, the first passivation contact layer 110 protrudes from the substrate 100 and is located above the groove 103. A light trapping structure is formed between the first passivation contact layer 110 and the substrate 100 based on the structure of the first passivation contact layer 110 to increase internal reflection.

The connecting layer 140 is located on the doped oxide layer 120 and is electrically connected to the second passivation contact layer 130. The part of the connecting layer 140 located on the doping oxide layer 120 indirectly contacts the first passivation contact layer 110 through the doping oxide layer 120, and due to the dielectric film characteristics of the doping oxide layer 120 itself and small carrier mobility, the leakage channel formed by the connecting layer 140 through the doping oxide layer 120 is limited, thereby moderately mitigating the hot spot effect while avoiding significant degradation of photoelectric conversion efficiency. The connecting layer 140 also contacts the side surface of the first passivation contact layer 110, so that the connecting layer 140 directly contacts the first passivation contact layer 110, and one end of the connecting layer 140 also directly contacts the second passivation contact layer 130, so that a direct leakage channel can be formed, thereby significantly mitigating the hot spot effect. Due to the limited contact area of the side surface and the constraints imposed by the deposition process, the thickness of the connecting layer 140 located on the side surface is not excessively large, and restricts the dimension of the leakage current path in this region, thereby avoiding significant degradation of photoelectric conversion efficiency. Through the two connection modes, the indirect contact of the connecting layer 140 with the first passivation contact layer 110 and the direct contact of the connecting layer 140 with the side surface 1120 of the first passivation contact layer 110, the hot spot effect is mitigated, so that the yield of the finally formed photovoltaic module and the photoelectric conversion efficiency of the back contact solar cell itself can be ensured.

In some embodiments, the connecting layer 140 contacts a top surface 123, a side surface 124 and a bottom surface 125 of the doped oxide layer 120.

In some embodiments, the material of the connecting layer 140 may be any material layer with conductivity, such as a metal layer, a doped semiconductor layer, a transparent conductive layer, or a metallic nitride layer.

In some embodiments, the connecting layer 140 has a thickness of 80 nm to 240 nm. Further, the thickness of the connecting layer 140 may be 100 nm to 200 nm. For example, the thickness of the connecting layer 140 is 80 nm, 100 nm, 130 nm, 150 nm, 180 nm, 210 nm, or 240 nm.

In some embodiments, the thickness of the connecting layer 140 is less than or equal to the thickness of the second passivation contact layer 130. In this way, by setting the connecting layer 140 to have a relatively small thickness, the size of the connecting layer 140 acting as a leakage current path is reduced, resulting in a relatively small leakage area. This configuration can decrease the number of electrons and holes recombined and improve the photoelectric conversion efficiency.

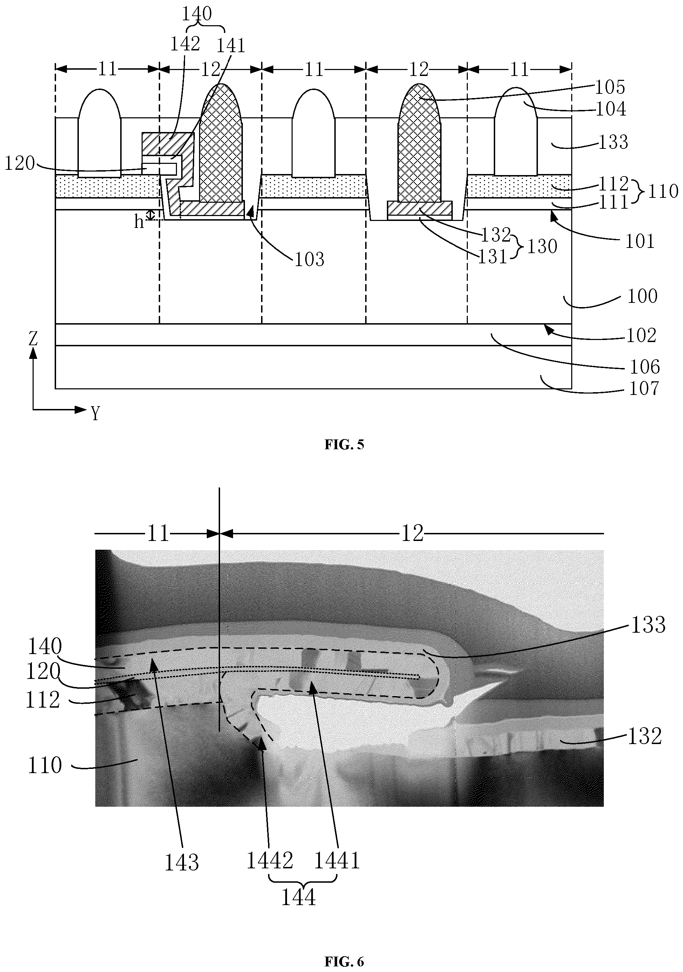

FIG. 5 is another cross-sectional view taken along A1-A2 in FIG. 1.

In some embodiments, referring to FIG. 5, the material of the connecting layer 140 is the same as the material of the second passivation contact layer 130, and the connecting layer 140 and the second passivation contact layer 130 forms a continuous film layer. The connecting layer 140 includes a third tunneling medium layer 141 and a third doped semiconductor layer 142 which are stacked, the material of the third tunneling medium layer 141 is the same as the material of the second tunneling medium layer 131, and the material of the third doped semiconductor layer 142 is the same as the material of the second doped semiconductor layer 132. The thickness of the third tunneling medium layer 141 is less than or equal to the thickness of the second tunneling medium layer 131, and the thickness of the third doped semiconductor layer 142 is less than or equal to the thickness of the second doped semiconductor layer 132.

FIG. 6 is a scanning electron microscope image of a back contact solar cell according to embodiments of the present disclosure.

In some embodiments, referring to FIG. 6, the connecting layer 140 includes a first connecting layer 143 and a second connecting layer 144. The first connecting layer 143 is located in a partial region of the first portion 121, and the second connecting layer 144 wraps around a partial region of the second portion 122 and is electrically connected to the second passivation contact layer 130. A thickness of the second connecting layer 144 is less than or equal to a thickness of the first connecting layer 143.

In some embodiments, referring to FIG. 6, a region of the second connecting layer 144 connected to the second passivation contact layer 130 is a first connection region 1442, and the remaining region of the second connecting layer 140 is a second connection region 1441. A thickness of the first connection region 1442 is less than a thickness of the second connection region 1441. By controlling the thicknesses of the connecting layer 140 and the second passivation contact layer 130 to reduce the area of the leakage channel, the leakage current is controlled.

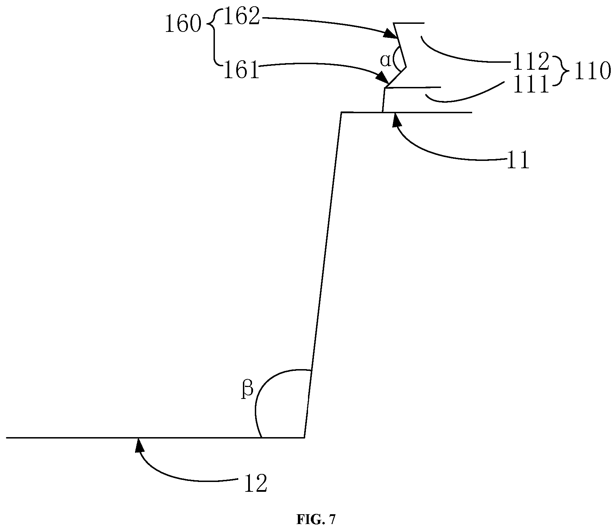

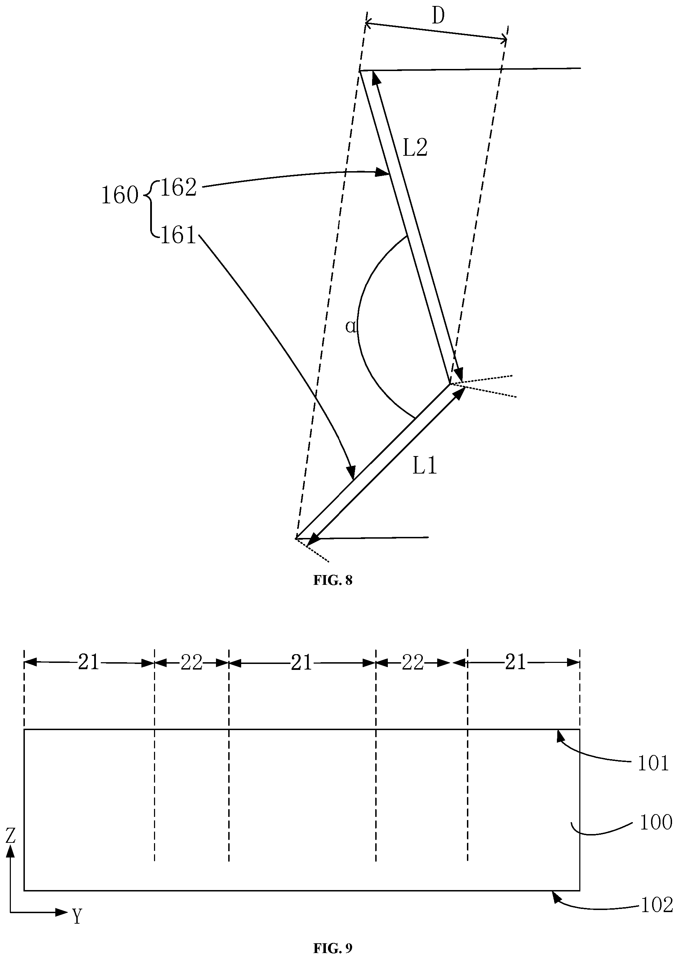

FIG. 7 is a partial enlarged view of a first passivation contact structure and the substrate 100 in a back contact solar cell according to embodiments of the present disclosure. FIG. 8 is a partial enlarged view of a first doped semiconductor layer 112 in the first passivation contact structure in FIG. 7.

In some embodiments, referring to FIGS. 7 and 8, the side surface of the fourth portion 1122 (see FIG. 4) has an inwardly concave recess 160, and the connecting layer 140 is at least partially located in the recess 160.

In some embodiments, with continued reference to FIG. 2, the back contact solar cell further includes a passivation layer 133 covering the first passivation contact layer 110, the connecting layer 140, and the second passivation contact layer 130.

In some embodiments, the passivation layer 133 may be of a single-layer structure or a stacked-layer structure, and the material of the passivation layer 133 may be one or more of silicon oxide, silicon nitride, silicon oxynitride, silicon oxynitride carbon, titanium oxide, hafnium oxide, or aluminum oxide.

In some embodiments, the back contact solar cell further includes an anti-reflection layer located on the surface of the passivation layer. The anti-reflection layer is configured to reduce or eliminate the reflected light on the surface of the back contact solar cell, thereby increasing the light transmittance of the surface of the back contact solar cell and reducing or eliminating the stray light of the system. The material of the anti-reflection layer includes silicon nitride or silicon oxynitride.

It should be noted that the scanning electron microscope image in FIG. 6 shows that the back contact solar cell includes the passivation layer, and the anti-reflection layer located on the passivation layer, but the anti-reflection layer is not marked. Boundaries between various film layers are schematically shown by dashed lines.

In some embodiments, the second surface 102 has a textured structure (not shown) including a plurality of pyramid structures. The back contact solar cell further includes a front passivation layer 106 covering the textured structure 114.

In some embodiments, the front passivation layer 106 may be of a single-layer structure or a stacked structure, and the material of the front passivation layer 106 may be one or more of silicon oxide, silicon nitride, silicon oxynitride, silicon oxycarbonitride, titanium oxide, hafnium oxide, or aluminum oxide.

In some embodiments, the material of the front passivation layer 106 is the same as the material of the passivation layer 133, and the front passivation layer 106 and the passivation layer 133 are prepared in the same preparation process.

With continued reference to FIG. 2, the back contact solar cell includes a first electrode 104 in electrical contact with the first doped semiconductor layer 112.

With continued reference to FIG. 2, the back contact solar cell includes a second electrode 105 in electrical contact with the second doped semiconductor layer 132.

In some embodiments, any one of the first electrode 104 and the second electrode 105 may be sintered from a burn-through metal paste or a laser-enhanced contact optimization (LECO) paste, and each of the metal paste and the LECO paste may include at least one of silver, aluminum, copper, tin, gold, lead, and nickel.

In some embodiments, the rear surface may have a concave-convex structure, that is, at least one of the first doped region 11, the second doped region 12, and the spacing region may have a concave-convex structure. The concave-convex structure can increase internal reflection of incident light, thereby improving the utilization rate of the incident light, and further improving the cell efficiency of the back contact solar cell.

It should be noted that FIG. 2 and FIG. 5 only illustrate an example in which the first electrode 104 penetrates the passivation layer to be in electrical contact with the first doped semiconductor layer 112 and the second electrode 105 penetrates the passivation layer to be in electrical contact with the second doped semiconductor layer 132. In an actual back contact solar cell, the connection relationship between the first electrode 104 and the first doped semiconductor layer 112 may be contact connection, or indirect connection through conductive particles; and the connection relationship between the second electrode 105 and the second doped semiconductor layer 132 may be contact connection, or indirect connection through conductive particles. The conductive particles may be silver crystals, silver agglomerates, silver particles, or other metal particles with conductivity.

In the back contact solar cell according to the embodiments of the present disclosure, the first doping regions 11 and the second doping regions 12 are provided on the substrate 100, and the first passivation contact layer 110 and the second passivation contact layer 130 are respectively formed on the first doping regions 11 and the second doping regions 12. The carrier recombination rate of the substrate surface can be reduced based on the chemical passivation and field passivation of the first passivation contact layer 110 and the second passivation contact layer 130, so that the photoelectric conversion efficiency of the back contact solar cell is improved. In addition, the connecting layer 140 is provided to be on the doping oxide layer 120 and electrically connected to the second passivation contact layer 130. A part of the connecting layer 140 located on the doping oxide layer 120 indirectly contacts the first passivation contact layer 110 through the doping oxide layer 120, and due to the dielectric film characteristics of the doping oxide layer 120 itself and small carrier mobility, the leakage channel formed by the connecting layer 140 through the doping oxide layer 120 is limited, thereby moderately mitigating the hot spot effect while avoiding significant degradation of photoelectric conversion efficiency. The connecting layer 140 also contacts the side surface of the first passivation contact layer 110, so that the connecting layer 140 directly contacts the first passivation contact layer 110, and one end of the connecting layer 140 also directly contacts the second passivation contact layer 130, so that a direct leakage channel can be formed, thereby significantly mitigating the hot spot effect. Due to the limited contact area of the side surface and the constraints imposed by the deposition process, the thickness of the connecting layer 140 located on the side surface is not excessively large, and restricts the dimension of the leakage current path in this region, thereby avoiding significant degradation of photoelectric conversion efficiency. Through the two connection modes, the indirect contact of the connecting layer 140 with the first passivation contact layer 110 and the direct contact of the connecting layer 140 with the side surface of the first passivation contact layer 110, the hot spot effect is mitigated, so that the yield of the finally formed photovoltaic module and the photoelectric conversion efficiency of the back contact solar cell itself can be ensured.

In addition, the doped oxide layer 120 is disposed on part of the first passivation contact layer 110, and can reduce the interface state charge on the surface of the first passivation contact layer 110, thereby improving the electric field distribution between the first passivation contact layer 110 and the connecting layer 140 and between the first passivation contact layer 110 and the substrate, and avoiding the generation of large leakage current and other adverse effects caused by the interface state charge. Further, the doped oxide layer 120 is located on the surface of part of the first passivation contact layer 110 and extends to the second doped region 12. In this way, the doped oxide layer 120, the first passivation contact layer 110 and the substrate 100 form a concave structure. The connecting layer 140 deposited on the film layer subsequently is formed to have a thickness not greater than a thickness of the second passivation contact layer 130 due to the shielding of the doped oxide layer 120, thereby reducing the size of the leakage channel to ensure the balance of the leakage current and the battery efficiency.

Accordingly, according to some embodiments of the present disclosure, another aspect of the embodiments of the present disclosure provides a preparation method of the back contact solar cell, which is used for preparing the solar cell provided in the above embodiments, and the same or corresponding technical features are not described in detail herein.

FIGS. 9 to 14 are sectional views of the back contact solar cell corresponding to various operations in a preparation method of the back contact solar cell provided in another embodiment of the present disclosure.

It should be noted that FIGS. 9 to 14 take the preparation method of the back contact solar cell in which the connecting layer 140 and the second passivation contact layer 130 are connected as an example. A preparation method different from that will be described below in another embodiment. The same or similar operations not described in detail.

Referring to FIG. 9 to FIG. 14, the method includes: providing a substrate 100 having a first surface 101 and a second surface 102 opposite to the first surface 101, the first surface 101 including first doping regions 11 and second doping regions 12 arranged alternatingly; forming a first passivation contact layer 110 over the first doping regions 11; forming a doping oxide layer 120, including a first portion 121 and a second portion 122, the first portion 121 being on a surface of the first passivation contact layer 110, the second portion 122 extending from the first portion 121 in the first direction and protrudes beyond the surface of the first passivation contact layer to be above the second doping regions 12; forming a second passivation contact layer 130 over the second doping regions 12, the second passivation contact layer 130 having a doping type different from a doping type of the first passivation contact layer 110; and forming a connecting layer 140 over a part of the first portion 121, where the connecting layer 140 wraps around a part of the second portion 122 and is electrically connected to the second passivation contact layer 130, and the connecting layer 140 extends along a side surface of the first passivation contact layer 110 and is electrically connected to the first passivation contact layer 110.

Referring to FIG. 9, the method includes: providing a substrate 100 having a first surface 101 and a second surface 102 opposite to the first surface 101, the first surface 101 having first processing regions and second processing regions arranged alternatingly. The first processing regions and the second processing regions have areas different from areas of subsequently formed first doping regions 11 and second doping regions 12.

The first surface 101 and the second surface 102 of the substrate 100 are flat surfaces. The second surface 102 is subjected to texturing. The texturing includes chemical etching. For example, the original substrate 100 may be cleaned by a mixed solution of potassium hydroxide and hydrogen peroxide, and the desired surface structure can be formed by controlling the concentration ratio of the potassium hydroxide to the hydrogen peroxide. In some embodiments, the surface structure may be formed by laser etching, mechanical method, or plasma etching. In the laser etching, the desired surface structure can be obtained by controlling laser process parameters. The surface structure includes a plurality of pyramid structures.

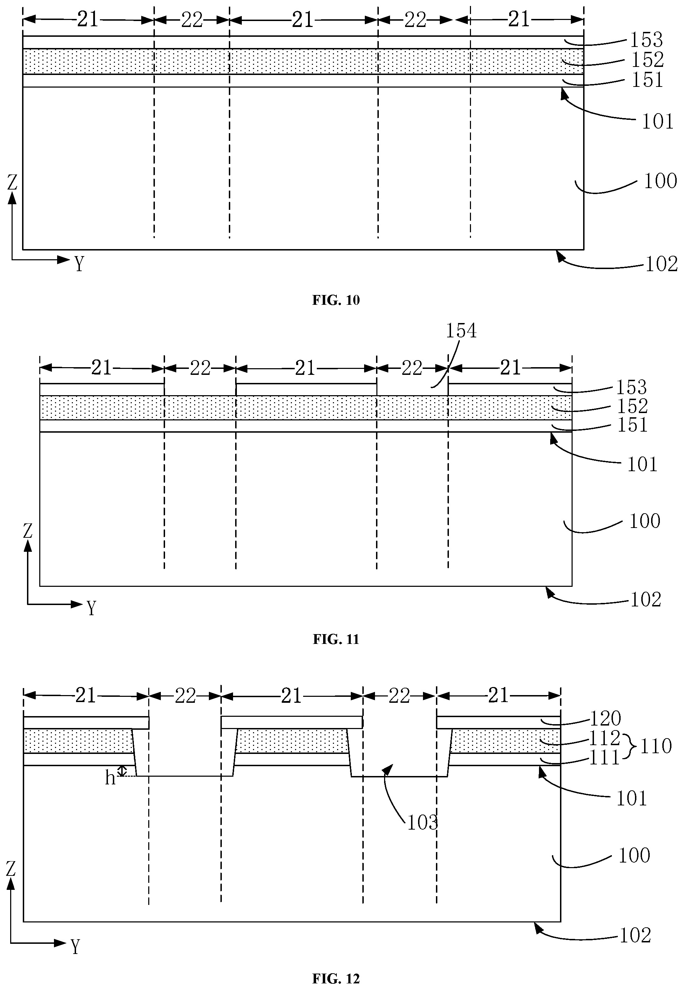

Referring to FIGS. 10 to12, the process operations of forming the first passivation contact layer 110 and the doped oxide layer 120 include: forming a first dielectric film, a first doped film, and an oxide film on the first surface 101 of the substrate 100; removing part of the oxide film over the second doped region 22 to expose a surface of the first doped film; removing the first dielectric film and the first doped film over the second doped region 22; and removing part of the oxide film over the first doped region 21 in the process of forming the second passivation contact layer 130, the remaining oxide film serving as the doped oxide film, and the remaining first dielectric film and first doped film serving as the first passivation contact layer 110.

In some embodiments, the substrate 100 is provided with the first processing regions 21 and the second processing regions 22.

In some embodiments, referring to FIG. 10, the method includes: forming a first dielectric film 151, a first doped film 152, and an oxide film 153 over the first processing regions 21 and the second processing regions 22.

In one example, process operations of forming the first dielectric film 151, the first doped film 152, and the oxide film 153 include: forming the first dielectric film 151 on the first processing region 21 and the second processing region 22 of the substrate 100 by a chemical vapor deposition process; forming a first amorphous silicon layer on the first dielectric film 151 by a plasma enhanced chemical vapor deposition (PECVD) process; forming a doping source layer on the surface of the first amorphous silicon layer by a PECVD process; and performing a doping process to migrate part of doping elements in the doping source layer to the first amorphous silicon layer, the first amorphous silicon layer being crystallized to form the first doped film 152, and the doping source layer being converted into the oxide film 153. In some embodiments, a thinning process is performed on the formed oxide film 153 to reduce a thickness of the oxide film 153.

Referring to FIG. 11, the oxide film 153 over the second processing region 22 undergoes patterned removal. The process of removing the oxide film 153 may be a laser etching process or a wet etching process.

Referring to FIG. 12, the first doped film 152 over the second doped region 12 is removed. Process parameters of removing the first doped film 152 include that an etching solution is an alkali solution, a concentration ratio in the alkali solution is 0.1 PPM (Parts per million) to 0.6 PPM, the etching time is 20 s to 500 s, and the etching temperature is 50 °C to 90 °C.

The substrate 100 is continuously etched to form the groove 103 during the process of removing the first doping film 152 over the second doping region 12.

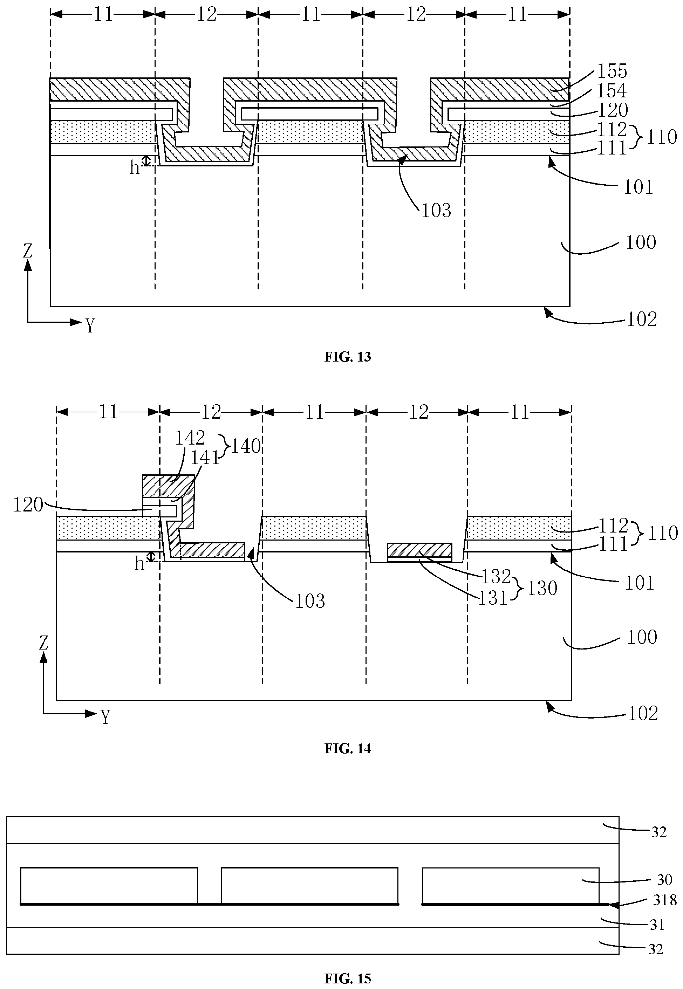

With reference to FIGS. 12 and 13, during the etching process, due to the etching solution's etching effect on the first doping film 152 and the isotropic nature of the etching, undercut etching occurs on a portion of the substrate 100 located in the first processing region 21 and below the oxide film, as well as on the first doping film 152. This forms a concave structure, defining an unetched end region of the substrate 100 as a boundary line between the first doping region 11 and the second doping region 12. Specifically, an unetched region of the substrate 100 forms the first doping region 11, while the etched region of the substrate 100 forms the second doping region 12.

Referring to FIG. 13, the process of forming the second passivation contact layer 130 includes forming a second dielectric film 154 and a second doping film 155 over the first doping region 11 and the second doping region 12. The second dielectric film 154 is located over the surface of the doping oxide layer 120, the inner wall and bottom surface of the groove 103, and the side surface of the first passivation contact layer 110. The second doping film 155 is located on the surface of the second dielectric film 154.

Referring to FIG. 14, parts of the second dielectric film and the second doping film over the first doping region 11 and at the boundary between the first doping region 11 and the second doping region 12 are removed. Since the leakage channel as shown in FIG. 1 needs to formed, a region where the leakage channel needs to be formed is not etched, and a mask is formed thereon. The mask can include any one of ink, paraffin, or a doped silicon glass layer. The etching process may include any one of a dry etching process, a wet etching process, or a laser etching process.

In some embodiments, an exposed doping oxide film is removed while removing the second dielectric film and the second doping film. Part of the remaining second dielectric layer and the second doping film serves as the connecting layer 140 and another part of the remaining second dielectric layer and the second doping film serves as the second passivation contact layer 130.

In other embodiments, parts of the second dielectric film and the second doping film at the boundary between the first doping region and the second doping region are removed, and the connecting layer is formed after the second passivation contact layer is formed.

With reference to FIG. 5, a passivation layer 133 is formed to cover the first doped semiconductor layer 112, the second doped semiconductor layer 132, the connecting layer 140, and the boundary between the first doped region 11 and the second doped region 12. A first electrode 104 is formed to be electrically connected to the first doped semiconductor layer 112. A second electrode 105 is formed to be electrically connected to the second doped semiconductor layer 132.

According to some embodiments of the present disclosure, another aspect of the present disclosure provides a tandem cell. The tandem cell includes: a bottom cell, which is the back contact solar cell prepared by the preparation method in any of the above embodiments or the back contact solar cell in any of the above embodiments; and a top cell, which is located on a side of the substrate of the bottom cell away from a front electrode.

In some embodiments, the tandem cell has a first gridline of a first polarity and a second gridline of a second polarity, where the first gridline refers to the first electrode of the back contact solar cell, and the second gridline refers to the second electrode of the back contact solar cell.

In some embodiments, an interface layer is disposed between the top cell and the bottom cell and covers the passivation contact structure on the rear surface.

It should be noted that the tandem cell in the embodiments of the present disclosure may be a two-layer solar cell, a three-layer solar cell, or a multi-layer stacked solar cell with more than three layers.

In some embodiments, the top cell may be a perovskite solar cell, which includes: a first transport layer, a perovskite substrate, a second transport layer, a transparent conductive layer, and an anti-reflection layer which are stacked in sequence. The first transport layer is opposite to the bottom cell.

In some embodiments, the first transport layer may be one of an electron transport layer and a hole transport layer, and the second transport layer may be the other of the electron transport layer and the hole transport layer.

According to some embodiments of the present disclosure, a still another aspect of the present disclosure provides a photovoltaic module. Referring to FIG. 15, the photovoltaic module includes: at least one cell string, each formed by connecting a plurality of back contact solar cells 30 in any of the above embodiments or prepared by the preparation method in any of the above embodiments; an encapsulation adhesive film 31, configured to cover a surface of the at least one cell string; and at least one cover plate 32, configured to cover a surface of the encapsulation adhesive film 31 away from the at least cell string. FIG. 15 is a sectional view of a photovoltaic module according to another embodiment of the present disclosure.

The photovoltaic module further includes a connecting part 318 configured to electrically connect two adjacent back contact solar cells 30. In some embodiments, a plurality of back contact solar cells 30 are connected to each other by connecting parts 318, where a respective connecting part 318 may be welded to a busbar or a finger on the back contact solar cell 30.

In some embodiments, the connecting part 318 is welded to a finger on a cell of the respective back contact solar cell, and the finger includes a first electrode and a second electrode. In some embodiments, the connecting part 318 is welded to a busbar on a cell of the respective back contact solar cell, and the busbar includes a first busbar and a second busbar, the first busbar is welded to the first electrode, and the second busbar is welded to the second electrode.

In some embodiments, the encapsulation film 31 includes a first encapsulation film and a second encapsulation film, the first encapsulation film covers one of the front surface and the rear surface of the back contact solar cell, and the second encapsulation film covers the other of the front surface and the rear surface of the back contact solar cell. Specifically, at least one of the first encapsulation film and the second encapsulation film may be an organic encapsulation film such as a polyvinyl butyral (PVB) film, an ethylene-vinyl acetate (EVA) film, a polyolefin elastomer (POE) film, or a polyethylene terephthalate (PET) film.

It should be noted that the first encapsulation film and the second encapsulation film have a boundary before the laminating process, and after the laminating process, the photovoltaic module is formed, and the concepts of the first encapsulation film and the second encapsulation film no longer exist, that is, the first encapsulation film and the second encapsulation film have formed the integral encapsulation film 31.

In some embodiments, the cover plate 32 may be a glass cover plate, a plastic cover plate, or the like with a light-transmitting function. Specifically, a surface of the cover plate 32 facing the encapsulation film 31 may be a concave-convex surface, thereby increasing the utilization rate of incident light. The cover plate 32 includes a first cover plate and a second cover plate, the first cover plate is opposite to the first encapsulation film, and the second cover plate is opposite to the second encapsulation film; or the first cover plate is opposite to one side of the back contact solar cell, and the second cover plate is opposite to the other side of the back contact solar cell.

Those skilled in the art should appreciate that that the preceding implementations are specific embodiments for implementing the present disclosure, and in practice, various changes may be made in the form and details without departing from the spirit and scope of the embodiments of the present disclosure. Any person skilled in the art may make variations and modifications without departing from the scope of the embodiments of the present disclosure. Therefore, the protection scope of the embodiments of the present disclosure shall be defined by the appended claims.

## Claims

1. A back contact solar cell, comprising:
a substrate (100), having a first surface (101) and a second surface (102) opposite to the first surface (101), wherein the first surface (101) includes first doped regions (11) and second doped regions (12) that are alternatingly arranged in a first direction (Y);
a first passivation contact layer (110), formed over the first doped regions (11);
a doped oxide layer (120), including a first portion (121) and a second portion (122), wherein the first portion (121) is on a surface of the first passivation contact layer (110) facing away from a respective first doped region (11), and the second portion (122) extends from the first portion (121) in the first direction (Y) and protrudes beyond the surface of the first passivation contact layer (110) to be above a second doped region (12) adjacent to the respective first doped region (11);
a second passivation contact layer (130), formed over the second doped regions (12), wherein the second passivation contact layer (130) has a doping type different from a doping type of the first passivation contact layer (110); and
a connecting layer (140), wherein the connecting layer (140) is over a part of the first portion (121) of the doped oxide layer (120), wraps around a part of the second portion (122) of the doped oxide layer (120), and is electrically connected to the second passivation contact layer (130), and the connecting layer (140) extends along a side surface of the first passivation contact layer (110) and is electrically connected to the first passivation contact layer (110).

2. The back contact solar cell according to claim 1, wherein the second portion (122) has a length of 0 µm to 3 µm in the first direction (Y).

3. The back contact solar cell according to claim 1, wherein a first distance between the second surface (102) and the respective first doped region (11) is greater than a second distance between the second surface (102) and the second doped region (12), the respective first doped regions (11) defines a groove (103) together with the second doped region (12), the second portion (122) is over the groove (103), the connecting layer (140) is over an inner side surface of the groove (103), and the second passivation contact layer (130) is over a bottom surface of the groove (103).

4. The back contact solar cell according to claim 3, wherein a difference between the first distance and the second distance is less than or equal to 5 µm.

5. The back contact solar cell according to claim 3, wherein the first passivation contact layer (110) is doped with a P-type doping element, and includes a third portion (1121) and a fourth portion (1122) that form a continuous layer, the third portion (1121) is opposite to the first portion (121), the fourth portion (1122) is opposite to the second portion (122), the fourth portion (1122) is over the groove (103), the second portion (122) is over the fourth portion (1122), and the connecting layer is over a side surface of the fourth portion (1122), and a bottom surface of the fourth portion (1122) facing away from the second portion (122).

6. The back contact solar cell according to claim 5, wherein the side surface of the fourth portion (1122) is provided with an inwardly concave recess (160), and the connecting layer is at least partially in the recess.

7. The back contact solar cell according to claim 3, wherein an included angle (β) between the bottom surface of the groove (103) and the side surface of the groove (103) is in a range of 110° to 150°.

8. The back contact solar cell according to any one of claims 1 to 7, wherein a material of the doped oxide layer (120) includes borosilicate glass, phosphosilicate glass, borophosphosilicate glass, or fluorophosphosilicate glass.

9. The back contact solar cell according to any one of claims 1 to 8, wherein a thickness of the connecting layer is less than or equal to a thickness of the second passivation contact layer (130).

10. The back contact solar cell according to any one of claims 1 to 9, wherein the connecting layer includes a first connecting layer (143) and a second connecting layer (144), the first connecting layer (143) is over the part of the first portion (121), the second connecting layer (144) wraps around the part of the second portion (122) and is electrically connected to the second passivation contact layer (130), and a thickness of the second connecting layer (144) is less than or equal to a thickness of the first connecting layer (143).

11. The back contact solar cell according to claim 10, wherein a first part of the second connecting layer (144) connected to the second passivation contact layer (130) has a thickness less than a thickness of a part of the second connecting layer (144) other than the first part.

12. The back contact solar cell according to any one of claims 1 to 11, wherein the first passivation contact layer (110) includes a first tunneling dielectric layer (111) over the first doped regions (11), and a first doped semiconductor layer (112) over a surface of the first tunneling dielectric layer (111) away from the substrate (100); and/or
wherein the second passivation contact layer (130) includes a second tunneling dielectric layer (131) over the second doped regions (12), and a second doped semiconductor layer (132) over a surface of the second tunneling dielectric layer (131) away from the substrate (100).

13. The back contact solar cell according to claim 12, wherein the doping oxide layer has the same doping element as the first doping semiconductor layer.

14. The back contact solar cell according to claim 12, wherein the doping oxide layer has doping elements including a first doping element of the first doped semiconductor layer (112) and a second doping element of the second doped semiconductor layer (132), and in the doping oxide layer, a doping concentration of the first doping element is greater than a doping concentration of the second doping element.

15. A photovoltaic module, comprising:
at least one cell string, each formed by connecting a plurality of back contact solar cells (30) according to any one of claims 1 to 14;
an encapsulation film (31), configured to cover a surface of the at least one cell string; and
at least one cover plate (32), configured to cover a surface of the encapsulation film (31) away from the at least one cell string.
